(19) **Europäisches Patentamt**
**European Patent Office**
**Office européen des brevets**

(11) **EP 4 152 542 A1**

(12) **EUROPEAN PATENT APPLICATION**

(43) Date of publication:
**22.03.2023 Bulletin 2023/12**

(21) Application number: **21306293.8**

(22) Date of filing: **17.09.2021**

(51) International Patent Classification (IPC):
**H02H 3/44** $^{(2006.01)}$     **H02H 7/122** $^{(2006.01)}$
**H02M 1/00** $^{(2006.01)}$     **H02M 1/32** $^{(2007.01)}$
**H03K 17/082** $^{(2006.01)}$

(52) Cooperative Patent Classification (CPC):
**H02H 7/1225; H02H 3/44; H02M 1/0009;**
**H02M 1/32; H02M 7/5387; H03K 17/0406;**
**H03K 17/0828;** H02H 3/023; H02M 1/0087;
H03K 2217/0027

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicants:
• **Mitsubishi Electric R&D Centre Europe B.V.**
**1119 NS Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR**
**HR HU IE IS IT LI LT LU LV MC MK MT NL NO PL**
**PT RO RS SE SI SK SM TR**

(72) Inventors:
• **Le Leslé, Johan**
**35708 RENNES CEDEX 7 (FR)**
• **Lefevre, Guillaume**
**35708 RENNES CEDEX 7 (FR)**

(74) Representative: **Plasseraud IP**
**66, rue de la Chaussée d'Antin**
**75440 Paris Cedex 09 (FR)**

(54) **OVERVOLTAGE PROTECTION FOR HIGH POWER CURRENT FED CONVERTERS USING DI(T)/DT SENSORS**

(57)     The disclosure concerns a method for protecting against overvoltage a current fed converter, comprising a switching cell having two or more legs, each leg being provided with at least one switching device (31, 32, 41, 42), in an open circuit failure condition of a switching device in a leg of said switching cell, comprising
- measuring (110) current derivative signals dIo/dt in respective upper switching devices (41, 42) or lower switching devices (31, 32) of at least two of said legs where a switching transition (ST1, ST2) occurs, said switching transition comprising a change of current conducting switching device (Q1, Q3) within said upper switching devices (41, 42) or lower switching devices (31, 32) and
- triggering a protection, based on said current derivative signals, when either:
o the absolute value of one of said current derivative signal being lower than a first predefined value k1 or null, or
o a sum of the absolute values of said current derivative signals being lower than a second predefined value k2, during said switching transition.

The disclosure also concerns an electronic circuit configured for implementing the method.

**(Cont. next page)**

**FIG. 4**

## Description

### Field of the invention

The present invention concerns high power current fed converters and overvoltage protection of such converters.

### Background

Current source converters are widely used for different applications, such as HVDC, motor drive or power factor corrector. A main limitation of such converter was the use of bulky input inductances. However, the growing emergence of wide bandgap semiconductor devices, e.g Silicone Carbide and/or Gallium Nitride semiconductor devices, with lower conductive and switching losses, opened up new perspectives for current fed converter design by reducing their size and improving their efficiency. Nevertheless, the use of Insulated Gate Bipolar Transistors (IGBT) is still up to date for high power applications and there is still room for improvement, especially dealing with protection.

In a current fed power converter composed of at least two legs, the switches of the different legs are controlled independently and in a complementary way, conducting to blocking and blocking to conducting. Between switching transitions (or switching events) between two switches, overlapping (both switches ON) is used. The main reason of the overlapping is due to the inductive nature of the input source. A DC link current interruption can be due to multiple factors including, wrong control signal of one of the two switches, a faulty device failed in open circuit or a failed gate driver. In consequence, no current path for the DC current can lead to tremendous damage. A current interruption in current fed converter induces a fast increase in the DC voltage, higher than the breakdown voltage of the power device causing the destruction of the power converter as the power device entering in the avalanche mode and dissipating the energy stored in the inductance, cannot withstand such high voltage and high current conditions during too much time. Current interruption in current fed converter is a fault that occurs from time to time and that most of the time leads to converter breakdown.

In addition, in high power applications, the increasing use of fast IGBT, faster than their counterpart IGCT (Integrated gate commutated Thyristor), requires reduced response time for the protection features. To avoid such an increase of the DC voltage upon current interruption and destruction of the power converter, a fast protection circuit ensuring a freewheeling path to the DC link current must be implemented.

Therefore, fast detection and protection circuit is required, which is addressed with the proposed invention.

An issue is that usual protection circuits are bulky and require several power devices such as diode, TVS (Transient Voltage Suppressor), thyristor, Metal Oxide Varistor (MOV).

Most of the time, such circuits are only used to clamp the overvoltage in an acceptable range but does not properly detected default to shut the converter down. Moreover, these protection circuits rely on voltage measurement meaning that the overvoltage event is already on going.

Furthermore, several of the usual solutions are increasing losses as they bring parasitic elements due the high number of power component (diode, etc) and the addition of parasitic capacitors is increasing the switching losses of the converter. In some cases, the protection circuit also conducts part of the power current, this can be the case in a Current Source Inverter.

In addition, a solution based on detection and ensuring a freewheeling path to the DC link current by a controller of the converter would not be fast enough.

### Summary of the invention

An objective of the present disclosure is to ensure a fast overvoltage protection due to current interruption in current fed converter. An approach is to intend to prevent as much as possible the voltage rises by monitoring the root cause being a current interruption.

The present disclosure also aims at limiting the use of bulky power devices such as diode, thyristor or TVS, by using low voltage analogic and logic circuits for the detection controlling only one power device ensuring the freewheeling path to the current.

More precisely the present disclosure concerns a method for protecting a current fed converter against overvoltage, said converter comprising a switching cell having two or more legs, each leg being provided with at least one switching device, in an open circuit failure condition of a switching device in a leg of said switching cell, which comprises:

- measuring current derivative signals dIo/dt in respective upper switching devices or lower switching devices of at least two of said legs where a switching transition occurs, said switching transition comprising a change of current conducting switching device within said upper switching devices or lower switching devices and
- triggering a protection, based on said current derivative signals, when either:

○ the absolute value of one of said current derivative signal being lower than a first predefined value k1 or null, or

○ a sum of the absolute values of said current derivative signals being lower than a second predefined value k2,

during said switching transition.

Such method may be easily implemented using analog and logic components for a fast detection and triggering of the protection.

The method may comprise synchronizing said measuring current derivative signals with switching transitions between said switching devices generated by a controller of the converter.

Said synchronizing comprises adjusting a blanking window starting with the beginning of the switching transition and ending, before, on or after the end of the switching transition, said blanking window inhibiting said triggering a protection during said switching transition.

The method may comprise a measurement of the sign of the output voltage across the switching cell for identifying the leading and freewheeling devices in the switching cell to define a width of the blanking window.

Said triggering a protection may comprise providing a current path outside the switching cell for a current source feeding said converter.

The method may comprise recording the fault status at the converter controller and/or transfer of the fault status of the converter at a remote controller after said triggering of a protection.

The present disclosure concerns also an electronic device for performing the method according to any one of the preceding claims characterized in that it comprises:

- means for measuring said current derivative signals;
- electronic circuit means configured for comparing said current derivative signals with said first predefined value or said second predefined value and triggering said protection;
- a protection device for ensuring an alternative path to the current fed from a current source outside the switching cell upon triggering of said protection by said electronic circuit means.

In said electronic device:

a - said means for measuring said current derivative signals may comprise sensors for sensing the current derivative of the current flowing through each leg of the switching cell, means for conditioning current derivative signals issued from said sensors,

b - said electronic circuit means may comprise:

- means for providing a first absolute value of a first current derivative signal and means for providing a second absolute value from a second derivative signal, and,
- either first comparator means, for comparing said first absolute value to said first predefined value K1 and providing a first logic output depending on the output state of said first comparator means, second comparator means for comparing said second absolute value to said first predefined value K1 and providing a second logic output depending on the output state of said second comparator means, and a logic gate connected to outputs of said first and second comparator means to provide a trigger signal for triggering said protection device when any one of said absolute values is lower than said first predefined value, or,
- summing means to provide a sum of said absolute values and a third comparator means for comparing said sum to said second predefined value and providing a third logic output depending on the output state of said third comparator to provide a trigger signal for triggering said protection device in case said sum of absolute values being lower than said second predefined value.

Said sensors for sensing said current derivative may be Rogowski coils.

Said means for conditioning said current derivative signals may comprise filter means and/or amplifier means.

Said means for measuring said current derivative signals and said electronic circuit means are preferably made of analog circuits and logic circuits. This permits a fast detection.

The protection device may comprise a protective switch to freewheel the current feeding the switching cell.

The electronic device may comprise a gate for enabling the trigger signal, said gate having as a first input said trigger signal and as a second input a blanking signal for inhibiting said trigger signal during at least part of the switching transition issued from a blanking circuit, said blanking signal issuing from the converter controller, said gate being configured to inhibit said trigger signal during occurrence of said blanking signal.

The disclosure also concerns a current fed converter comprising an electronic device wherein said electronic device is provided on a PCB board within said converter.

The proposed method can be applied to any current fed converter composed of at least two legs, each including at least one controllable switching device. The switching devices are controlled alternatively and an overlapping of the control signals ensuring current continuity in the switching devices where a transition occurs is included during normal operations.

Multiple combinations of the current derivative sensor outputs can be implemented to design the overvoltage protection. The logical and conditioning circuits must be designed according to the signal combinations.

### Brief description of the drawings

A detailed description of exemplary embodiments of the invention will be discussed hereunder in reference to the attached drawings where:

| | |
|---|---|
| Figure 1: | shows a simplified two legs current fed converter design; |
| Figure 2: | shows a simplified drawing of an upper part of a current fed converter with current derivative detection sensors; |
| Figures 3A | and 3B: show respectively a first and second embodiments of method steps in accordance with the disclosure; |
| Figure 4: | shows more detailed method steps in accordance with said first embodiment; |
| Figure 5: | shows waveforms according to a first transition event without open circuit fault; |
| Figure 6: | shows the first transition event of figure 5 with open circuit fault; |
| Figure 7: | shows waveforms according to a second transition event without open circuit fault; |
| Figure 8: | shows the second transition event of figure 7 with open circuit fault; |
| Figures 9A and 9B: | show two embodiments of a fault detection circuit; |
| Figure 10: | shows a Rogowski coil applicable to the disclosure. |

### Detailed description of embodiments of the invention

The present invention concerns a method and device to prevent overvoltage in a current fed converter.

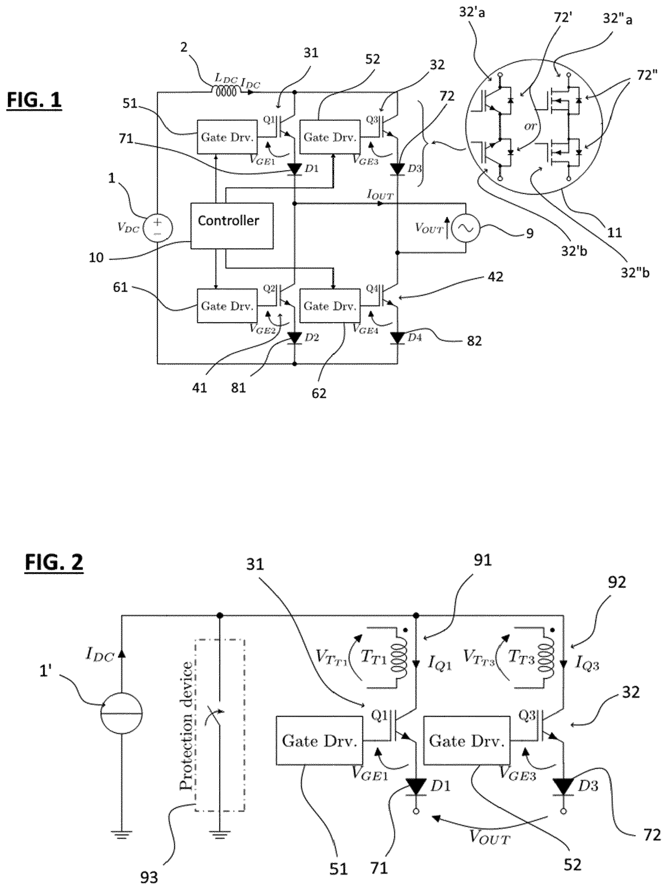

A simplified schematic of such a converter is given in figure 1 where the converter, fed by a DC source 1 through an inductance 2 comprises a switching cell having two legs each comprising an upper branch having a switching device 31,32 and each comprising a lower branch having a switching device 41, 42 such as an IGBT, each branch being further provided with a series diode 71, 72, 81, 82 to block possible reverse voltage across the IGBTs.

The gates of the IGBTs are under control of gate drivers 51, 52 for the upper IGBTs 31,32 and 61, 62 for the lower IGBTs 41, 42, each gate driver being under control of a controller which provides the control signals of the gate drivers according to the switching sequence of the converter in order to provide an alternating current to a load 9.

As seen in zoomed window 11, If a current bidirectional capability is required, the combination IGBT and series diode can be replaced by two common Emitter IGBTs 32'a, 32'b and anti-parallel diodes 72'. The following description is based on IGBT application but can be extended to any unipolar JFET, IGFET, HEMT, MOSFET 32"a, 32"b or bipolar BJT transistor and only the name of the electrodes needs to be changed.

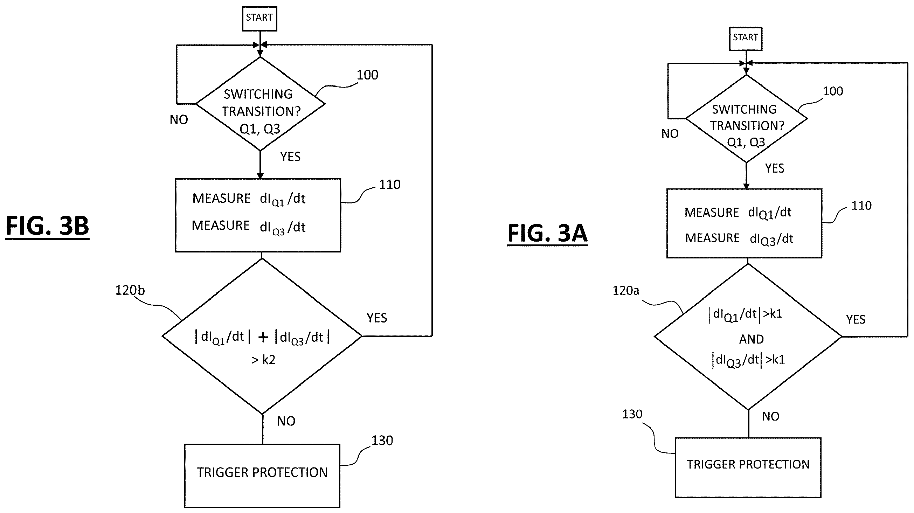

Figure 2 is a simplified schematic view of an upper part of the switching cell with derivative current sensing means 91, 92 as per the present disclosure in series with upper switch devices Q1 31 and Q3 32 provided with their gate drivers 51, 52. The current source including the power source 1 and inductance 2 of figure 1 is shown with reference 1' and the protective device is shown as a protective switch 93. A similar circuit is provided in the lower part of the switching cell with Q2 and Q4 and the following method applies both to the upper part of the cell and the lower part of the cell in identical manner. Figures 3A and 3B show the basic principle of the method of the present disclosure in the case of switching events between the switches Q1, Q3 of the upper part of the legs of the switching cell.

In figure 3A, is disclosed a first embodiment where the method comprises detecting switching events between Q1 and Q3 at step 100, measuring the current derivative signals in Q1 and Q3 at step 110, comparing the absolute values of such current derivative signals in step 120 with a first predefined value k1 and, in case one of the two derivative signals being lower than the first predefined value k1, triggering a protection in step 130.

In figure 3B, is disclosed a second embodiment of the method where a sum of the two derivative currents absolute values are compared to a second predefined value k2 and triggering the protection in step 130 is done in the event that such sum is lower than the second predefined value k2.

While the method is shown as flowcharts, measurement step 110, comparison steps 120a, 120b and triggering step 130 are implemented using analog components and logic components instead of software embedded in the controller of the converter in order to have a real time response.

Step 100 is a step initiated by the controller 10 of the converter and consists in changing the conduction state between the two switch devices 31 and 32 of the switching cell, a first switching event comprising Q1 changing from blocked state to conducting state and Q3 changing from conducting state to blocked state with a delay with respect to Q1 and a second switching event being Q3 changing from blocked state to conducting state and Q1 changing from conducting state to blocked state with a delay with respect to Q3.

Summing the two absolutes values has the advantage to provide a higher signal/noise ratio and to provide a simpler detection circuit.

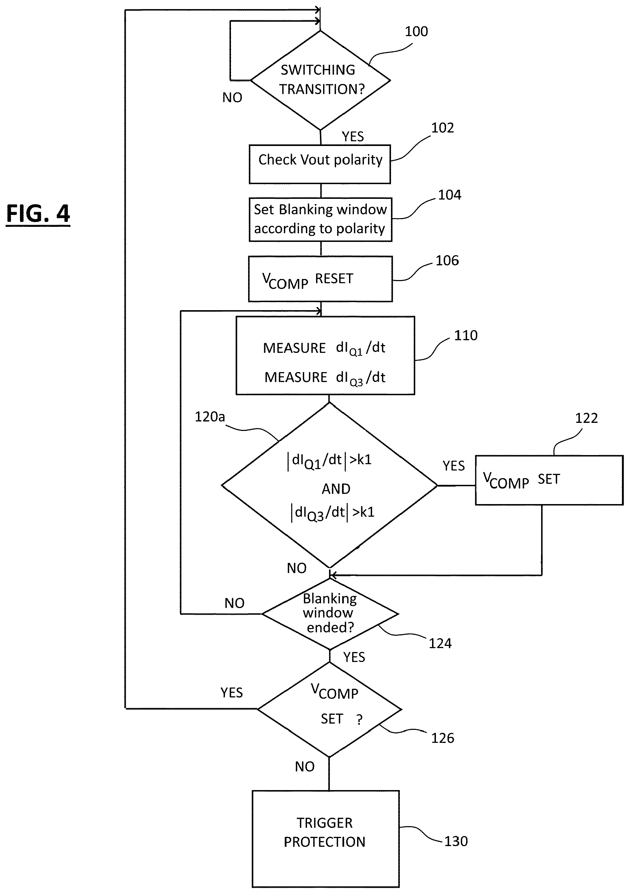

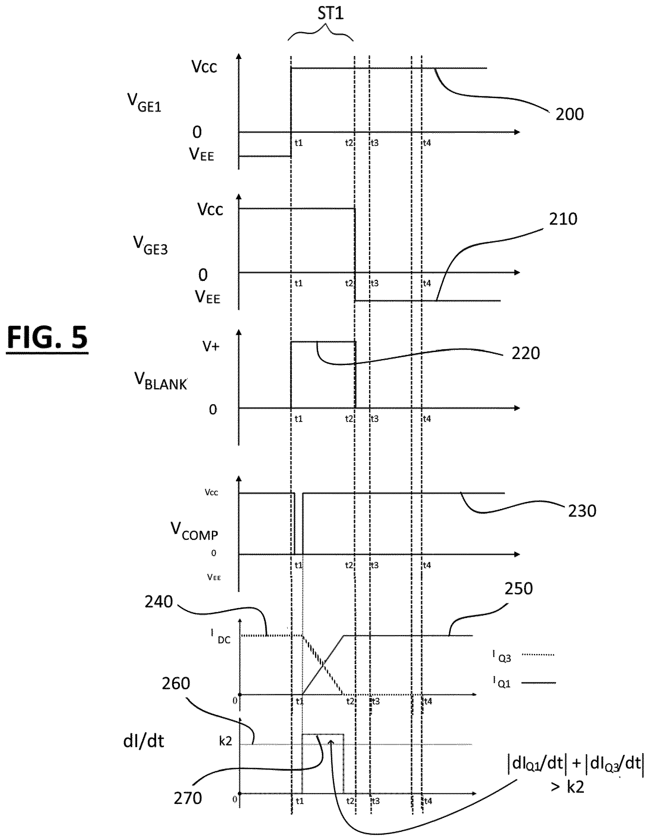

Figure 4 provides an example of the first embodiment with more details and comprising the provision of setting a blanking window at step 104 to inhibit a fault signal triggering the protection while the switching event is not ended as will be seen in figures 5 to 8 providing signals waveforms.

Such blanking window having a duration in accordance with the polarity of the output voltage $V_{OUT}$ which is determined at prior step 102.

As soon as the blanking window is set, a detection signal $V_{COMP}$ is reset by the controller 10 at step 106 to be ready for the detection. This detection signal will then be set or not depending on the presence of sufficiently high dI/dt signals in the monitored legs of the converter. It should be noted that the steps of resetting the detection signal and setting the blanking window are provided within the controller of the converter. Checking the polarity may be done before starting of the switching event and the blanking window may be set by the controller on or before initiating the switching event. After setting the blanking window, if both dI/dt absolute values are detected above the predefined value k1 at step 120a, the $V_{COMP}$ signal is set at step 122 and after the end of the blanking window at step 124. In such case, the protection is not initiated, and the method comprises awaiting another switching event. In case the dI/dt signals are too low to set $V_{COMP}$, such signal remains reset and a protection of the converter is triggered at step 130.

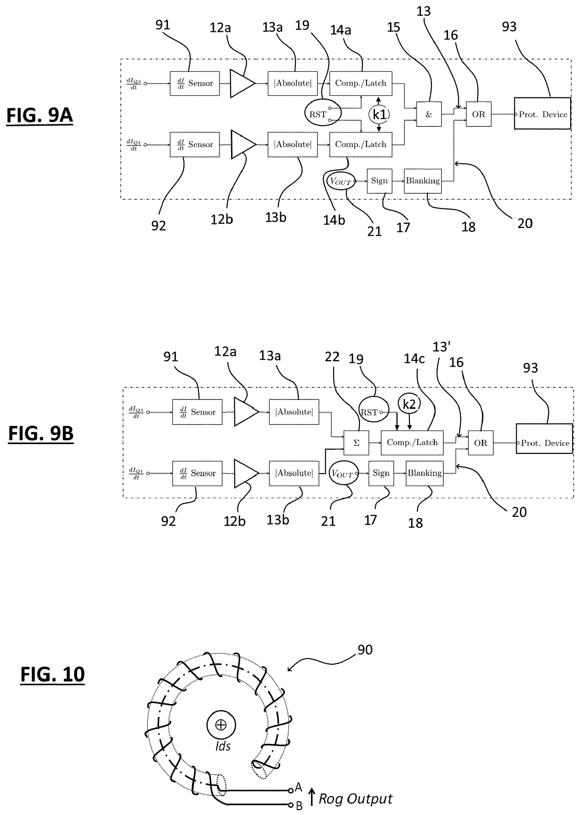

Figure 9A provides a schematic view of a first embodiment of a detection circuit of the disclosure.

Starting from the two legs sensors 91, 92 the circuit comprises amplifier circuits 12a, 12b, absolute value detectors or rectifiers 13a, 13b, comparators with latches 14a, 14b having a reset signal input for a reset signal 19 from the controller of the converter and an input for the first predefined signal value k1 to which the two absolute values are to be compared. The logical outputs of the comparators with latches are input in a logic AND gate 15 and its output 13 is input in a OR gate 16 having as a second input the output signal 20 of a blanking circuit 18 of the controller 10. The output of the OR gate 16 provides the final trigger signal which triggers the protection device 93 in case one of the two derivative current signals is too weak.

In this example, the output signal of the AND gate 15 provides a logical 0 trigger signal while the blanking signal is a logical 1 signal making gate 16 a OR gate to inhibit the trigger signal until the blanking window ends. Other logic gates may be used in case of a logical 1 trigger signal and/or a logical 0 blanking signal.

Figure 9B corresponds to the second embodiment where the outputs of the absolute values detectors or rectifiers 13a, 13b are summed in adder 22 and the result is compared in a comparator with latch 14c. In such case the logic output of the comparator 14c becomes the input of the OR gate 16 together with the blanking window signal 20.

In the embodiments of figures 9A, 9B, the absolute function 13a, 13b is used to obtain a positive signal from the sensors independently of current derivative sign. Several ways are possible to implement such a function such as full bridge diode rectifier or precision operational amplifier rectifier. Any circuit able to obtain absolute value of any alternative signal can be used.

The comparator with latch function 14a, 14b, 14c is similar as a sample and hold circuit it can be implemented by using any kind of peak detector circuit or any comparator having a latch pin to maintain the output at a high state. A clamping circuit can be inserted at the input for security reason as the signal from the current derivative sensors can be higher than maximum rating.

The summation of the current derivative sensors outputs 22 can be done by connecting the sensors in series or either by using dedicated circuit using operational amplifiers circuits.

With respect to the Sign module 17 and Blanking module 18, most of the time current fed converters are controlled by vector modulation in the controller 10, meaning the switching devices are known, even in multi-phase converters by the controller allowing said sign module and blanking module to be handled by the controller. In addition, having the sign of the output voltage, especially the sign of the voltage across the switching cell allows identifying the leading and freewheeling devices in the switching cell. Therefore, duration of the blanking window can be adjusted in the controller to be able to protect the converter in all switching configurations as will be seen hereunder.

The AND function 15 is required with the first embodiment as one comparator is used for each $\frac{dI}{dt}$ sensor. If at least one of the two output of the comparator is low, it will trigger the protection.

The OR function 16 is used with the blanking signal to avoid false triggering. This function can be used using simple diode, dedicated IC or discrete transistors.

The reset signal RST 19 is used to pull down the comparator output before starting a new switching event commutation.

The protection device 93 is used as freewheeling path to the DC current to avoid the voltage overshoot. It can be the same type as the power device used in the converter (IGBT, MOSFET, ...).

The amplifiers 12a, 12b may comprise low pass filters to avoid transient signals to create false detections.

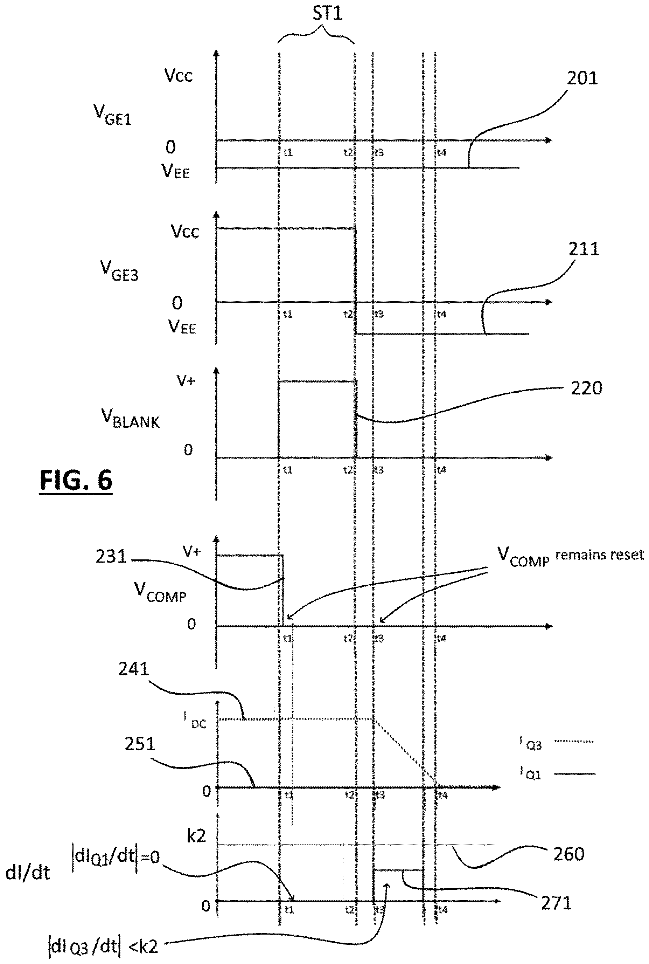

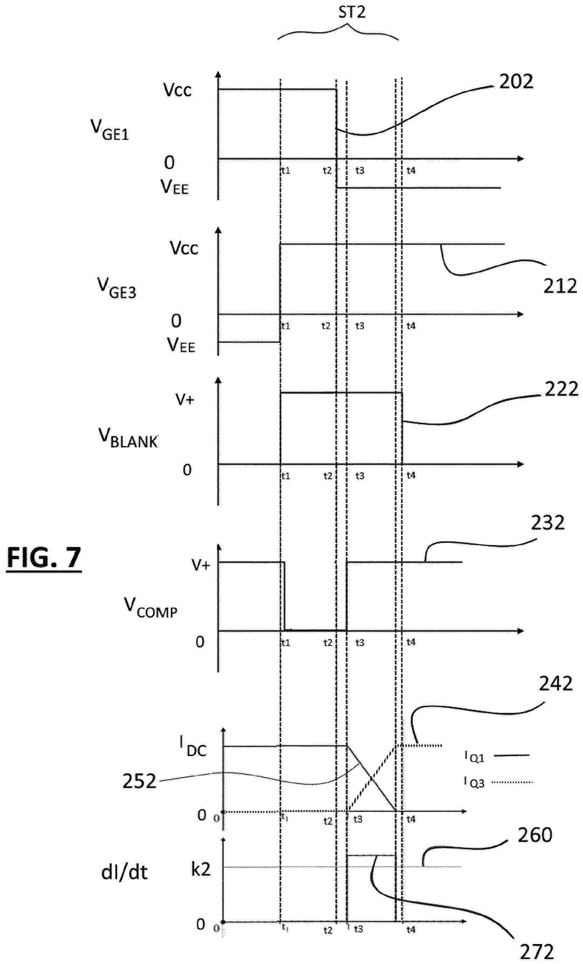

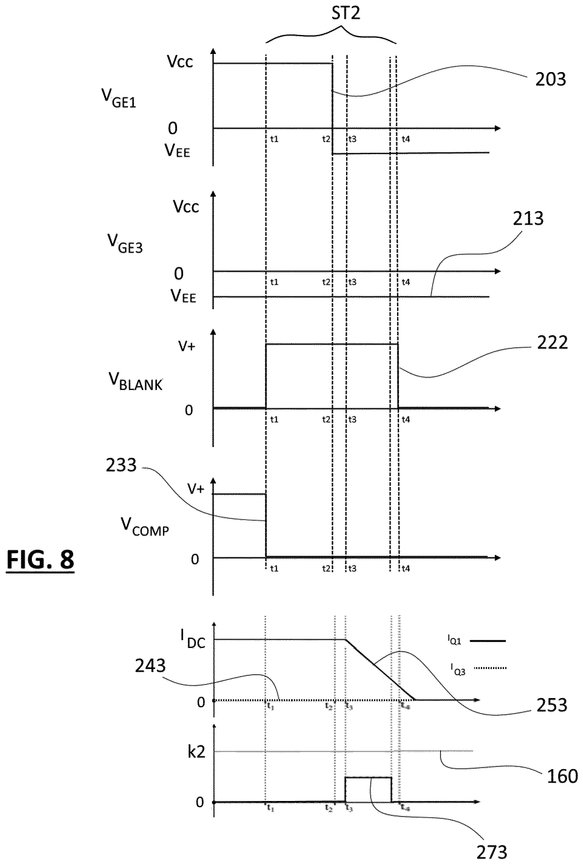

The operation of the method in term of signals is disclosed in figures 5 to 8 for two different types of switching events ST1 for figures 5 and 6 and ST2 for figures 7 and 8. Figures 5 and 7 describe switching events without open circuit fault and figures 6 and 8 show switching events where a fault occurs. The explanations will be done according to the following assumptions and initial state:

- IGBT devices with series diode are considered in the switching cell,
- The output corresponding to Vout of the load 9 is considered constant at the switching time scale,
- The sign of the output voltage is known,
- The DC current is considered constant during the transition time scale,
- The switch Q1 is considered as the leading device meaning that the current variation only occurs due to a change on Q1,
- The protection device is represented as an open switch in normal operation and can be one or multiple controllable semiconductor devices. The hereunder explanations consider that the current derivative absolute values are summed and compared with the k2 predetermined value.

In the two types of switching events or transitions discussed, Q1 is considered as the leading device and Q3 the freewheeling device. Similar explanations apply with a reverse situation. Figure 5 and figure 6 are presenting a switching transition ST1 with Q1's turn-on under normal conditions and under fault, respectively. Figure 7 and figure 8 present a switching transition ST2 with Q1's turn-off under normal and under fault condition, respectively. The detection/protection circuit acts differently according to the switching transition. Indeed, knowing the sign of the output voltage allows identifying the leading device, thus the switching type also.

In figure 5, In normal operation, for $0 \leq t < t1$ the top switch Q3 is ON and the switch Q1 is OFF. The gate voltages $V_{GE3}$ 210 and $V_{GE1}$ 200 are respectively in high (positive) and low (negative) state. The DC current is flowing through Q3 from Collector (C) to Emitter (E) meaning that $I_{Q3}$ 240 equals IDC. At $t = t1$ the control signal from the controller is sent to Q1, it corresponds to the overlapping instant. At $t = t1$ the blanking window signal $VB_{LANK}$ 220 also toggles from low to high state, momentarily disabling the overvoltage detection circuit. After a certain delay, which depends on the power device (turn on or turn off delay time), the current 250 flowing through Q1 increases with a positive current derivative, while the current derivative in Q3 is negative in normal operation. The $\frac{dI(t)}{dt}$ sensors placed as presented in figure 2 react, therefore the sum of the absolute value of the sensor output voltages increase as represented by signal 170. In normal operation the sensed dI/dt absolute value sum is higher than the fixed reference k2 thus latching the comparator output $V_{COMP}$ 230 until the next commutation. At $t = t2$, the gate voltage of Q3 is pulled down meaning the overlapping time is over, the blanking window $VB_{LANK}$ 220 which in such case of positive transition of Q1 goes from t1 to t2 also ends.

Under fault condition of Q1 as described in figure 6, the switch Q1 is not able to turn on. The initial conditions are the same as previously, the current 241 in Q3 is the DC current of the load. The blanking window $V_{BLANK}$ 220 starts at t1. Contrarily to normal operation, no change occurs in Q1 current 251 between t1 and t2 and $V_{GE1}$ 201 remains low. In consequence abs(dI$_{Q1}$/dt) is null. The comparator output $V_{COMP}$ 231 is not latched and remains reset. At $t = t2$, the gate signal 211 of Q3 is pulled down as the blanking signal, meaning a default occurred. The protection device is triggered before the DC current intends to be interrupted.

In figure 6, the commutation of Q3 should have arrived at t3, however since the protection is turned on at t2, even if abs(dI$_{Q3}$/dt) 271 was greater than the reference k2, the converter is stopped. It can be said that the current transition between t3 and t4 corresponds to the current flowing from Q3 to the freewheeling circuit provided by the protection circuit.

The turn-off sequence, presented in figures 7 and 8, is slightly different. In figure 7 without fault, before t1 the switch Q1 is ON and the switch Q3 is OFF. The gate voltage $V_{GE1}$ 102 of Q1 and the gate voltage $V_{GE3}$ 112 of Q3 are respectively in high (positive) state and low (negative) state. The DC current is flowing through Q1 from Collector (C) to Emitter (E) meaning that IQ1 = IDC. At $t = t1$ the control signal from the controller is sent to Q3, it corresponds to the overlapping instant, both switches Q1 and Q3 can carry the DC current. Despite the state change of Q3, nothing happens, the current still flow through Q1. At $t = t1$ the blanking signal $V_{BLANK}$ 122 also toggles from low to high state, momentarily disabling the overvoltage detection circuit. At $t = t2$, the gate voltage of Q1 is pulled down meaning the overlapping time is over. After a certain delay, which depends on the power devices (turn on or turn off delay time), at $t = t3$ the current flowing through Q3 increases with a positive current derivative, while the current derivative in Q1 is negative in normal

operation. The $\dfrac{dI(t)}{dt}$ sensors placed as presented in **Erreur ! Source du renvoi introuvable.** react, therefore the sensor output voltages increase as represented by the dI/dt signal 272 which is higher than the predefined voltage value k2 thus triggering latching the comparator output $V_{COMP}$ 232 until the next commutation.

In such case of a negative transition of Q1, the blanking window has a duration from t1 to t4 as the current transition occurs between t3 and t4 but the transition starts with the controller intending to turn Q3 on.

In abnormal operation as in figure 8, where the switch Q3 does not turn on the DC current and $V_{GE3}$ 113 remains low, the turn-off of Q1 is different. Indeed, the semiconductor intends to interrupt the current at t2 due to the corresponding control signal $V_{GE1}$ 103, however the inductive nature of the source forces the current. The potential at the collector of Q1 will rise causing Q1 to enter in avalanche mode. Therefore, the output signals from the current derivative sensors will be lower than in normal conditions and quasi null, respectively to Q1 and Q3 and dI/dt 173 is lower than the predefined voltage value k2. Thus, the comparator output cannot be latched before the end of the blanking signal causing the circuit to trigger the protection device.

According to these analyses it is possible to state that the default always occurred after the last falling edge of the control signal which issues at the output of the AND gate having $V_{COMP}$ and $V_{BLANK}$ as inputs.

Typical durations of a switching transition event for IGBTs are:

t1 to t2: from 10 $\mu$s to several hundred of micro-seconds, being the overlapping time;
t2 to t3: depends on the devices, rated voltage, rated current, chip design and the performances of the gate driver, it corresponds to the turn ON/OFF delay time in the range of 10 $\mu$s to 100 $\mu$s;
t3 to t4: may correspond to the current transition in normal operation, also depends on the device and gate driver performances, thus the range can also be wide from 10 $\mu$s to several hundred of micro-seconds.

The following steps are summed-up the operation of the protection in abnormal conditions:

1. During Q1's unable to turn-on:

a. The control tries to turn Q1 on (t = t1 in normal condition),
b. The blanking signal toggles from low to high at the same time, step 1,
c. The control sends the signal to Q3 to turn off at t = t2,
d. The blanking signal toggles from high to low, no current derivative signal occurred during the blanking window,
e. The absence of signal at high state ($V_{BLANK}$ or $V_{COMP}$) triggers the protection device before the current interruption happens;

2. During Q1's turn-off and Q3 unable to turn on:

a. The control sends the signal to Q3 to turn on at t = t1, Q1 is still conducting the DC current,
b. The blanking signal toggles from low to high at the same the time,
c. The control sends the signal to Q1 to turn off at t = t2,
d. After a certain delay the current in Q1 decays slowly as Q1 enters in avalanche mode staring from t = t3,
e. The corresponding current derivative signals are lower than the fixed threshold,
f. The blanking signal toggles from high to low,
g. The absence of signal at high state ($V_{BLANK}$ or $V_{COMP}$) triggers the protection device.

The disclosed method and device, using discrete components which may be located on the PCB having the switch devices, provides an extremely fast detection capability especially during the turn-on of the leading device. Such device is particularly useful in view of the switching transitions durations.

The same method and device apply for Q2 and Q4 in the lower part of the legs of the converter and other transition events between the switching devices.

With respect to current derivative sensors, the purpose of the dI/dt sensors is to generate a signal that is proportional to the time rate of change of the collector current of the power switch. When the current IC flowing through the power device is going from a high to a low value the output signal is positive. Conversely when the current IC of the power device is going from a low to a high value the output signal is negative. This function can be done by using a Rogowski coil which is a wound coil surrounding a main conductor as presented in figure 10. The Rogowski coil may be integrated in a PCB using several layers of conductors of such PCB and designed to provide a signal of a few volts.

Other types of derivative current sensors may also be used.

The invention is not limited to the provided examples and as said before, the same principle may apply to the lower legs parts switches devices and the output of the electronic protection device may be additionally connected to an input of the controller of the converter in order to provide a warning signal which may be in turn sent to a remote controller or management system.

**Claims**

1. Method for protecting against overvoltage a current fed converter, comprising a switching cell having two or more legs, each leg being provided with at least one switching device (31, 32, 41, 42), in an open circuit failure condition of a switching device in a leg of said switching cell, **characterized in that** it comprises:

   - measuring (110) current derivative signals dlo/dt in respective upper switching devices (41, 42) or lower switching devices (31, 32) of at least two of said legs where a switching transition (ST1, ST2) occurs, said switching transition comprising a change of current conducting switching device (Q1, Q3) within said upper switching devices (41, 42) or lower switching devices (31, 32) and
   - triggering a protection, based on said current derivative signals, when either:

     ∘ the absolute value of one of said current derivative signal being lower than a first predefined value k1 or null, or
     ∘ a sum of the absolute values of said current derivative signals being lower than a second predefined value k2,

   during said switching transition.

2. Method according to claim 1, comprising synchronizing said measuring current derivative signals with switching transitions (ST1, ST2) between said switching devices (31, 32) generated by a controller (10) of the converter.

3. Method according to claim 2, wherein said synchronizing comprises adjusting a blanking window starting with the beginning of the switching transition (ST1, ST2) and ending, before, on or after the end of the switching transition, said blanking window inhibiting said triggering a protection during said switching transition.

4. Method according to claim 3 comprising a measurement of the sign of the output voltage across the switching cell for identifying the leading and freewheeling devices in the switching cell to define a width of the blanking window.

5. Method according to any one of claims 1 to 4, wherein said triggering a protection comprises providing a current path outside the switching cell for a current source feeding said converter.

6. Method according to any one of the preceding claims, comprising recording the fault status at the converter controller and/or transfer of the fault status of the converter at a remote controller after said triggering of a protection.

7. Electronic device for performing the method according to any one of the preceding claims **characterized in that** it comprises:

   - means for measuring said current derivative signals;
   - electronic circuit means configured for comparing said current derivative signals with said first predefined value or said second predefined value and triggering said protection;
   - a protection device for ensuring an alternative path to the current fed from a current source outside the switching cell upon triggering of said protection by said electronic circuit means.

8. Electronic device according to claim 7 wherein:

   a - said means for measuring said current derivative signals comprise sensors (1a, 1b) for sensing the current derivative of the current flowing through each leg of the switching cell, means (2a, 2b) for conditioning current derivative signals issued from said sensors,
   b - said electronic circuit means comprise:

     - means (3a) for providing a first absolute value of a first current derivative signal and means (3b) for providing a second absolute value from a second derivative signal, and,

- either first comparator means (4a), for comparing said first absolute value to said first predefined value K1 and providing a first logic output depending on the output state of said first comparator means, second comparator means (4b) for comparing said second absolute value to said first predefined value K1 and providing a second logic output depending on the output state of said second comparator means, and a logic gate (5) connected to outputs of said first and second comparator means to provide a trigger signal (13) for triggering said protection device when any one of said absolute values is lower than said first predefined value,

or,

- summing means (11) to provide a sum of said absolute values and a third comparator means (12) for comparing said sum to said second predefined value and providing a third logic output depending on the output state of said third comparator to provide a trigger signal (13) for triggering said protection device in case said sum of absolute values being lower than said second predefined value.

9. Electronic device according to claim 8 wherein said sensors for sensing said current derivative are Rogowski coils.

10. Electronic device according to claim 8 or 9 wherein said means for conditioning said current derivative signals comprise filter means and/or amplifier means.

11. Electronic device according to any one of claim 7 to 10 wherein said means for measuring said current derivative signals and said electronic circuit means are made of analog circuits and logic circuits.

12. Electronic device according to any one of claims 7 to 11 wherein the protection device comprises a protective switch to freewheel the current feeding the switching cell.

13. Electronic device according to any one of claims 7 to 12 comprising a gate (6) for enabling the trigger signal, said gate having as a first input said trigger signal (13) and as a second input a blanking signal (14) for inhibiting said trigger signal during at least part of the switching transition issued from a blanking circuit (7, 8), said blanking signal issuing from the converter controller, said gate being configured to inhibit said trigger signal during occurrence of said blanking signal.

14. Current fed converter comprising an electronic device according to any one of claims 7 to 13 wherein said electronic device is provided on a PCB board within said converter.

**FIG. 1**

**FIG. 2**

## FIG. 3B

START

SWITCHING TRANSITION? Q1, Q3 — 100

NO

YES

MEASURE $dI_{Q1}/dt$
MEASURE $dI_{Q3}/dt$ — 110

120b — $|dI_{Q1}/dt| + |dI_{Q3}/dt| > k2$

YES

NO

TRIGGER PROTECTION — 130

## FIG. 3A

START

SWITCHING TRANSITION? Q1, Q3 — 100

NO

YES

MEASURE $dI_{Q1}/dt$
MEASURE $dI_{Q3}/dt$ — 110

120a — $|dI_{Q1}/dt| > k1$ AND $|dI_{Q3}/dt| > k1$

YES

NO

130 — TRIGGER PROTECTION

EP 4 152 542 A1

**FIG. 4**

**FIG. 5**

**FIG. 6**

**FIG. 7**

FIG. 8

**FIG. 9A**

**FIG. 9B**

**FIG. 10**

Europäisches
Patentamt

European
Patent Office

Office européen
des brevets

# EUROPEAN SEARCH REPORT

Application Number

EP 21 30 6293

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | DE 27 22 814 A1 (AEG ELOTHERM GMBH) 23 November 1978 (1978-11-23) * the whole document * | 1-14 | INV. H02H3/44 H02H7/122 H02M1/00 H02M1/32 H03K17/082 |
| Y | JP H02 182384 A (HONDA MOTOR CO LTD) 17 July 1990 (1990-07-17) * the whole document * | 1-14 | |
| X | US 2016/216332 A1 (GAJANAYAKE CHANDANA JAYAMPATHI [SG] ET AL) 28 July 2016 (2016-07-28) * abstract; figures 1,2,4,10,11 * * paragraphs [0003] - [0006], [0010] - [0019], [0040], [0062] - [0071], [0091] - [0092]; table 1 * | 1-14 | |
| A | US 2018/294711 A1 (YOSHIDA TOMOKAZU [JP]) 11 October 2018 (2018-10-11) * abstract; figures 2,3 * * paragraphs [0014] - [0028] * | 1-14 | |

TECHNICAL FIELDS
SEARCHED      (IPC)

H02H
H03K
H02M

The present search report has been drawn up for all claims

| Place of search | Date of completion of the search | Examiner |
|---|---|---|
| Munich | 2 March 2022 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 30 6293

This annex lists the patent family members relating to the patent documents cited in  the above-mentioned European search report.
The members are as contained in the European Patent Office EDP file on
The European Patent Office is in no way liable for these particulars which are merely given for the purpose of information.

02-03-2022

| Patent document cited in search report | | Publication date | Patent family member(s) | | Publication date |
|---|---|---|---|---|---|
| DE 2722814 | A1 | 23-11-1978 | NONE | | |
| JP H02182384 | A | 17-07-1990 | NONE | | |
| US 2016216332 | A1 | 28-07-2016 | GB | 2535010 A | 10-08-2016 |
| | | | US | 2016216332 A1 | 28-07-2016 |
| US 2018294711 | A1 | 11-10-2018 | CN | 108696155 A | 23-10-2018 |
| | | | DE | 102018107771 A1 | 18-10-2018 |
| | | | JP | 6420399 B1 | 07-11-2018 |
| | | | JP | 2018182852 A | 15-11-2018 |
| | | | US | 2018294711 A1 | 11-10-2018 |

EPO FORM P0459

For more details about this annex : see Official Journal of the European Patent Office, No. 12/82